(19) Europäisches Patentamt European Patent Office Office européen des brevets

(11) **EP 4 270 021 B1**

(12) **EUROPEAN PATENT SPECIFICATION**

(45) Date of publication and mention
of the grant of the patent:
**11.06.2025 Bulletin 2025/24**

(21) Application number: **23168668.4**

(22) Date of filing: **19.04.2023**

(51) International Patent Classification (IPC):
*G01R 27/08* (2006.01)    *G01R 27/16* (2006.01)
*G01R 31/00* (2006.01)    *G01R 31/28* (2006.01)
*B60L 3/00* (2019.01)

(52) Cooperative Patent Classification (CPC):
**B60L 3/0046; G01R 27/08; G01R 31/006;
G01R 31/2827**

(54) **DEVICE AND METHOD FOR MEASURING A RESISTANCE VALUE OF A RESISTOR OF A SAFETY DEVICE OF AN ELECTRIC OR HYBRID VEHICLE**

VORRICHTUNG UND VERFAHREN ZUR MESSUNG EINES WIDERSTANDSWERTS EINES WIDERSTANDES EINER SICHERHEITSEINRICHTUNG EINES ELEKTRO- ODER HYBRIDFAHRZEUGS

DISPOSITIF ET PROCÉDÉ DE MESURE D'UNE VALEUR DE RÉSISTANCE D'UNE RÉSISTANCE D'UN DISPOSITIF DE SÉCURITÉ D'UN VÉHICULE ÉLECTRIQUE OU HYBRIDE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **28.04.2022 IT 202200008525**

(43) Date of publication of application:
**01.11.2023 Bulletin 2023/44**

(73) Proprietor: **Iveco SpA
10156 Torino (TO) (IT)**

(72) Inventor: **Moni, Manuele
10156 Torino (IT)**

(74) Representative: **Fiume, Orazio et al
Praxi Intellectual Property S.p.A.
Corso Vittorio Emanuele II, 3
10125 Torino (IT)**

(56) References cited:
**US-A1- 2013 035 819    US-A1- 2013 257 446
US-A1- 2014 285 210**

**Description**

**Field of the invention**

The present invention relates to the field of methods for measuring a power resistance in safety devices of electric or hybrid vehicles. In which the safety devices are arranged to discharge a capacitive electric energy, stored in the vehicular electric network, in the event of an accident.

**State of the art**

ISO 26262, entitled "Road vehicles - Functional safety", is an international standard for the functional safety of electrical and/or electronic systems installed in production road vehicles, defined by the International Organization for Standardization (ISO) in 2011, and revised in 2018.

According to the risk analysis and assessment performed on the basis of the ISO 26262 standard, a safety mechanism is required to discharge the residual electrical capacity of the propulsion mains after disconnecting the propulsion batteries in emergency situations such as of an accident and in general for emergency situations which could result in an electric shock.

The discharge of the residual capacity is achieved by means of special resistors.

US2014/285210 discloses a safety device for electric or hybrid vehicles arranged to discharge a capacity electrical energy of the vehicle power network in the event of an accident. US2014285210 teaches to monitor the discharge time and current.

US2013/035819 relates to a high-voltage system for a motor vehicle where a discharge circuit is disclosed for discharging a capacitor through a resistor and switching means. It discloses a diagnostic method based on the analysis of the voltage profile across the resistor during discharging.

US2013/257446 discloses an apparatus for diagnosing a discharge circuit including PTC. The evaluation is based on measuring the voltage across the discharging resistor at one of a plurality of times.

However, it is essential to be able to monitor the resistance value of the resistors.

It is, in fact, known that the resistance value tends to increase with the aging of the components. This can lead to discharge times of the residual capacity of the vehicular electrical network, which are not compatible with the above mentioned standard.

In the automotive field, the processing units that supervise the monitoring and control of a vehicle are equipped with data interfaces and processing units that have analog interfaces such as to perform the aforementioned measurements of the resistance value and with galvanic isolation of such interfaces.

The sensors on board of the vehicle are therefore arranged to communicate with the processing unit via the vehicle data network with intrinsic peculiarities of each sensor. For example, voltage sensors have a sampling frequency of the order of 30 ms, while current sensors have a sampling frequency of the order of 10 ms, therefore it is difficult to obtain simultaneous voltage and current measurements.

In fact, the measurements must be performed during the discharge of the residual capacity, preferably at the beginning of it, with voltage and current values that vary over time.

To these uncertainties must also be added the uncertainties deriving from the transmission time of the data packets containing the voltage and current measurements, along the vehicular data network.

Therefore, currently, the only possible solution is to perform dedicated measurements using an external measuring device equipped with appropriate voltage and current sensors, in order to calculate the resistance value as the ratio between voltage and current.

According to a safety device produced by the present Applicant, the number of resistors is relatively high to have a sufficient degree of redundancy and to distribute any current peaks.

Evidently, the fact that a single safety device is equipped with a large number of resistors further complicates the problem of monitoring each resistor, independently of the others, so as to promptly intervene with its replacement. Unless specifically excluded in the detailed description that follows, what is described in this chapter is to be considered as an integral part of the detailed description.

**Summary of the invention**

The object of the present invention is to propose a device and method for measuring the power resistance of an electric or hybrid vehicle.

The technical problem arises specifically in the automotive field, in which the processing unit responsible for monitoring and controlling vehicle functions is not equipped with analog interfaces with galvanic isolation but only with data interfaces. Therefore, measurement information circulates over a vehicular data network.

The basic idea of the present invention is to carry out the measurement of the initial voltage, before the activation of the discharge of the residual capacity and to average the current values for a time interval between the start of the discharge and the achievement of a preordained voltage threshold. Subsequently, the initial value of the discharge current is calculated by multiplying said average value by 5, then the resistance value is calculated as the ratio between the initial voltage and the initial current. Evidently, the voltage is measured across the resistor, while the measured current flows through the resistor. Advantageously, it is possible to obtain an estimate of the resistance value of the resistor, with a much better precision than the tolerances of the resistor itself.

The dependent claims describe preferred variants of the invention, forming an integral part of the present description.

## Brief description of the figures

Further objects and advantages of the present invention will become clear from the detailed description that follows of an embodiment of the same (and of its variants) and from the annexed drawings given for purely explanatory and non-limiting purposes, in which:

Fig. 1 shows an equivalent electric circuit diagram for measuring a resistance value of a resistor of a safety device for discharging the capacitive currents stored in a vehicular electric network;
Fig. 2 shows the voltage and discharge current diagrams;
Fig. 3 shows an example of a flow diagram of the method object of the present invention.

The same reference numbers and letters in the figures identify the same elements or components or functions.

It should also be noted that the terms "first", "second", "third", "superior", "inferior" and the like may be used herein to distinguish various elements. These terms do not imply a spatial, sequential, or hierarchical order for the modified items unless specifically indicated or inferred from the text.

The elements and characteristics illustrated in the various preferred embodiments, including the drawings, can be combined with each other without however departing from the scope of protection of the present application as described below.

## Detailed description

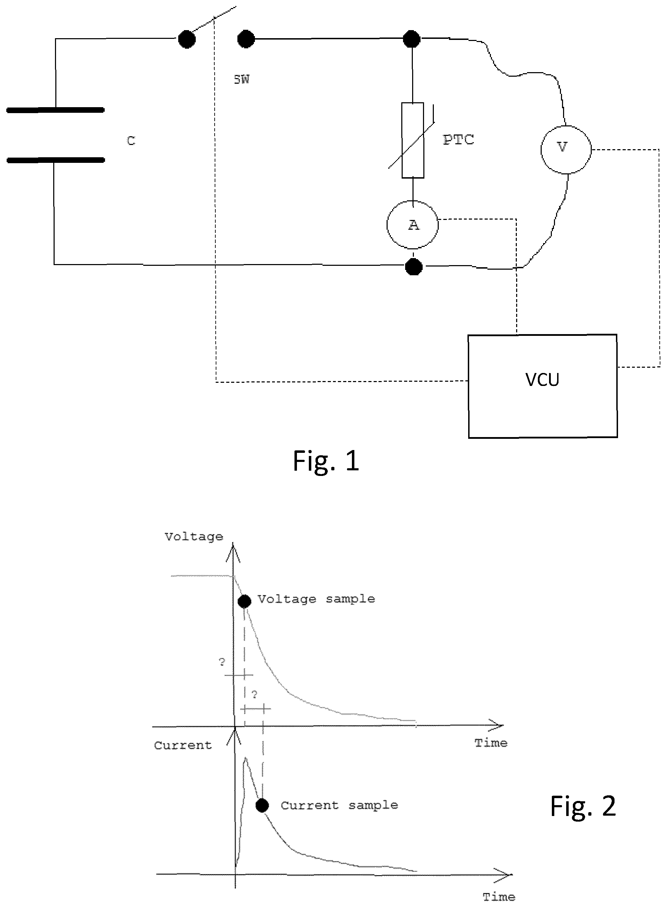

Fig. 1 shows an example of an electromechanical layout of a safety device DEV for discharging the residual currents stored in the vehicular electric circuit C, which is schematized as a capacitor.

The resistor PTC is indicated with the abbreviation of a Positive Temperature Coefficient, generally indicated with the abbreviation PTC. However, it may also not be Positive Temperature Coefficient resistor.

The processing unit VCU is arranged to control the discharge switch SW and to acquire information about voltage and current measurements by means of the sensors V and A respectively, through the vehicular data network. Therefore, the sensors are connected to the processing unit via a vehicular data network, for example, of the CAN or LIN type.

With reference to Fig. 2, two simultaneous time diagrams are shown, respectively representative of voltage and discharge current.

On the voltage and current graphs representative of a discharge procedure, black dots are arranged. These black dots indicate the sampling time positions of voltage and current respectively and for this reason the relative offset with respect to the ordinate axis is indicated with question marks, as it is not possible to know exactly when these samples are acquired and therefore, it is not possible to calculate the resistance value as a ratio of simultaneous pairs of voltage and current values.

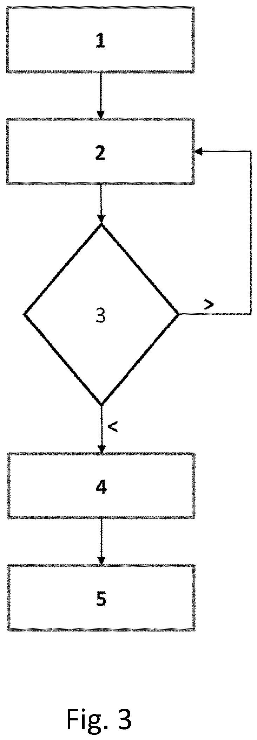

With reference to figure 3, according to the present method the following steps are performed in succession:

- (Step 1) Acquisition of an initial voltage measurement while the switch SW is open, i.e. the electric circuit is isolated,
- (Step 2) Closing of the switch SW and simultaneous measurement of the discharge current and of the voltage across the resistor, until the measured value of the voltage exceeds (">") said preordained threshold (S),
- (Step 3) detection of the instant in which the measured voltage value becomes lower ("<") than the aforementioned threshold, then
- (Step 4) Calculation of the average of the acquired current values and calculation of the initial current of the discharge as the product of the average of the current values by 5,
- (Step 5) Calculation of the resistance value as the ratio between the initial voltage value and the initial current value.

The VCU, thanks to the present invention, is able to monitor any aging of the discharge resistances by appropriately signalling the need for maintenance of the safety system.

The electrical network discharge procedure and the contextual measurement of the resistance value of the resistor PTC can be planned according to predetermined time intervals.

The present invention is inspired by the fact that the law governing the discharge current is given by

$$i \ = \ \frac{V}{R} e^{\frac{-t}{\tau}} \quad \Rightarrow \overline{I} \ = \ \int_0^{5\tau} \frac{V}{R} e^{\frac{-t}{\tau}} \ dt/5\tau \ = \ \left[ \frac{-V\tau}{R} e^{\frac{-t}{\tau}} \right]_0^{5\tau} /5\tau \ =$$

$$= \ \frac{V}{5R} (1 \ - \ 0,007) \quad \Rightarrow \frac{5}{0,993} \overline{I} = \frac{V}{R} \Rightarrow \frac{V}{R} \simeq 5\overline{I}$$

Furthermore, the value of the average current $\overline{I}$ is given by the integral between 0 and 5tau divided by this time interval. From which it can be deduced that the average current during the discharge multiplied by a factor of about 5 leads to the initial current value sought to evaluate the V/I ratio. The exact value of the factor is equal to 5.035, however it is believed that there is no particular advantage in using the exact value rather than its approximation 5.00.

It is interesting to note that the initial voltage value can be measured before closing the switch SW and therefore, its measurement can be uncorrelated from the current measurements performed during the discharge of the vehicular electric circuit C.

With regard to step 3 of comparing the voltage value measured with the threshold S, it provides that as long as the voltage value measured exceeds the threshold S, then the loop closes on step 2, therefore, the switch SW is kept closed and the sampling of the measured voltage and current values is continued.

According to a preferred variant of the invention in step 3, the samples of the measured current are rejected if they are lower than a predetermined current threshold, selected taking into account the precision of the implemented current sensor.

For example, the switch can be opened after calculating the resistance value in Step 5 or within step 4.

The different samples acquired during the discharge, with a sampling step of 10 ms for example, each represents an average value within the sampling interval.

This implies that the averaging operation in step 4 is an average of the averages.

Alternatively, a moving average can be performed and the calculated value of the moving average can be acquired at the instant in which the measured voltage value becomes lower than the aforementioned threshold S.

The value of the threshold S is equal to 0.007 multiplied by the value of the initial voltage.

The processing unit is configured to command the discharge of the propulsion electric network capacity following the detection of an impact and/or vehicle overturning. Such events, for the purposes of the present invention are referred to generically as an "accident".

The present invention can advantageously be implemented through a computer program comprising coding means for carrying out one or more steps of the method, when this program is executed on a computer. Therefore it is understood that the scope of protection extends to said computer program and also to computer-readable means comprising a recorded message, said computer-readable means comprising program coding means for carrying out one or more steps of the method, when said program is run on a computer.

Variants of the non-limiting example described are possible, without however departing from the scope of protection of the present invention, including all equivalent embodiments for a person skilled in the art, to the contents of the claims.

From the description given above, the person skilled in the art is capable of realizing the object of the invention without introducing further constructive details.

**Claims**

1. Method of measuring a resistance value of a resistor (PTC) of a safety device for electric or hybrid vehicles arranged to discharge a capacitive electric energy of a vehicular electric network, in the event of an accident, the method comprising the procedure of triggering an electric discharge through said resistor and of calculating (Step 5) said electric resistance value as the ratio between an initial voltage value, measured before the triggering of the electric discharge, and an estimated initial current value equal to an average value of the discharge current multiplied by a factor equal to 5 or 5.035, wherein the average value of the current is calculated in a time interval starting from an instant of the triggering of the electric discharge up to an instant in which the voltage value is equal to a threshold of 0.007 times said initial value.

2.  Method according to claim 1, comprising the following steps in succession:

    - (Step 1) Acquisition of said initial voltage measurement while the switch (SW) is open,
    - (Step 2) Closing of the switch (SW) and simultaneous measurement of the discharge current and of the voltage across the resistor, until the measured value of the voltage exceeds (">") said preordained threshold (S),
    - (Step 3) detection of the instant in which the measured voltage value becomes lower ("<") than the aforementioned threshold, then
    - (Step 4) Calculation of the average of the acquired current values and calculation of the initial current of the discharge as the product of the average of the acquired current values by said factor.

3.  Method according to any one of claims 1 or 2, wherein said average value of the discharge current is calculated by means of a moving average.

4.  A computer program comprising program coding means adapted to implement all steps of any one of claims 1 to 3, when said program is run on a vehicle processing unit (VCU) configured to control and monitor a device of safety for electric or hybrid vehicles arranged to discharge a capacitive electric energy of a vehicular electric network, in the event of an accident.

5.  A computer readable means comprising a recorded program, said computer readable means comprising a program coding means adapted to carry out all steps of any one of claims 1 to 3, when said program is run on a vehicular processing unit (VCU) configured to control and monitor a safety device for electric or hybrid vehicles arranged to discharge a capacitive electrical energy of a vehicular electrical network, in the event of an accident.

6.  A vehicular processing unit (VCU) configured to control an electric or hybrid vehicle safety device arranged to discharge a capacitive electrical energy of a vehicular electrical network, in the event of an accident, the processing unit being configured to measure a value of electrical resistance of a resistor of said safety device by triggering an electric discharge through said resistor and calculating said electrical resistance value as the ratio between an initial voltage value, measured before the triggering of the electric discharge, and an initial current value equal to an average value of the discharge current multiplied by a factor equal to 5 or 5.035, in which the average value of the current is calculated in a time interval starting from an instant of the triggering of the electric discharge up to an instant in which the value of the voltage is equal to 0.007 times said initial value.

7.  Electric or hybrid vehicle comprising

    - a vehicular electrical network,
    - a vehicular data network,
    - a safety device arranged for discharging a capacitive electric energy from the vehicular electrical network by means of at least one resistor (PTC), in the event of an accident, the device comprising a voltage sensor (V) and a current sensor (A) arranged to measure respectively a voltage across the at least one resistor and a discharge current flowing through said at least one resistor, and wherein said voltage and current sensors are operatively connected to said vehicular data network,
    - a processing unit (VCU), operatively connected to said vehicular data network and arranged to cause an activation of said safety device,

    and wherein said processing unit is in accordance with claim 6.


**Patentansprüche**

1.  Verfahren zum Messen eines Widerstandswerts eines Widerstands (PTC) einer Sicherheitsvorrichtung für Elektro- oder Hybridfahrzeuge, das dazu angeordnet ist, im Falle eines Unfalls eine kapazitive elektrische Energie eines Fahrzeugstromnetzes zu entladen, wobei das Verfahren den Vorgang umfasst, eine elektrische Entladung durch den Widerstand auszulösen und den elektrischen Widerstandswert als Verhältnis zwischen einem vor dem Auslösen der elektrischen Entladung gemessenen Anfangsspannungswert und einem geschätzten Anfangsstromwert (Schritt 5) zu berechnen, der einem Durchschnittswert des Entladungsstroms multipliziert mit einem Faktor von 5 oder 5,035 entspricht, wobei der Durchschnittswert des Stroms in einem Zeitintervall berechnet wird, das mit dem Zeitpunkt des Auslösens der elektrischen Entladung beginnt und bis zu einem Zeitpunkt reicht, an dem der Spannungswert dem 0,007-fachen des Anfangswerts entspricht.

2. Verfahren nach Anspruch 1, das nacheinander die folgenden Schritte umfasst:

- (Schritt 1) Erfassen der anfänglichen Spannungsmessung bei geöffnetem Schalter (SW),
- (Schritt 2) Schließen des Schalters (SW) und gleichzeitige Messung des Entladungsstroms und der Spannung über dem Widerstand, bis der gemessene Spannungswert den vorgegebenen Schwellenwert (S) (">") überschreitet,
- (Schritt 3) Erkennen des Zeitpunkts, in dem der gemessene Spannungswert ("<") niedriger als der vorgenannte Schwellenwert wird, dann
- (Schritt 4) Berechnen des Durchschnitts der erfassten Stromwerte und Berechnung des anfänglichen Entladungsstroms als Produkt des Durchschnitts der erfassten Stromwerte mit dem genannten Faktor.

3. Verfahren nach einem der Ansprüche 1 oder 2, wobei der Durchschnittswert des Entladungsstroms mittels eines beweglichen Durchschnitts berechnet wird.

4. Computerprogramm, das Programmcodierungsmittel umfasst, die angepasst sind, um alle Schritte eines der Ansprüche 1 bis 3 auszuführen, wenn das Programm auf einer Fahrzeugverarbeitungseinheit (VCU) ausgeführt wird, die konfiguriert ist, um eine Sicherheitsvorrichtung für Elektro- oder Hybridfahrzeuge zu steuern und zu überwachen, die dazu eingerichtet ist, im Falle eines Unfalls eine kapazitive elektrische Energie eines Fahrzeugstromnetzes zu entladen.

5. Computerlesbares Mittel, das ein aufgezeichnetes Programm umfasst, wobei das computerlesbare Mittel ein Programmcodierungsmittel umfasst, das angepasst ist, um alle Schritte eines der Ansprüche 1 bis 3 auszuführen, wenn das Programm auf einer Fahrzeugverarbeitungseinheit (VCU) ausgeführt wird, die konfiguriert ist, um eine Sicherheitsvorrichtung für Elektro- oder Hybridfahrzeuge zu steuern und zu überwachen, die dazu eingerichtet ist, im Falle eines Unfalls eine kapazitive elektrische Energie eines Fahrzeugstromnetzes zu entladen.

6. Fahrzeugverarbeitungseinheit (VCU), die so konfiguriert ist, dass sie im Falle eines Unfalls eine Sicherheitsvorrichtung für ein Elektro- oder Hybridfahrzeug steuert, die so angeordnet ist, dass sie eine kapazitive elektrische Energie eines Fahrzeugstromnetzes entlädt, wobei die Verarbeitungseinheit so konfiguriert ist, dass sie einen Wert des elektrischen Widerstands eines Widerstands dieser Sicherheitsvorrichtung misst, indem sie eine elektrische Entladung durch diesen Widerstand auslöst, und den elektrischen Widerstandswert als Verhältnis zwischen einem Anfangsspannungswert, der vor dem Auslösen der elektrischen Entladung gemessen wurde, und einem Anfangsstromwert berechnet, der einem Durchschnittswert des Entladungsstroms multipliziert mit einem Faktor von 5 oder 5,035 entspricht, wobei der Durchschnittswert des Stroms in einem Zeitintervall berechnet wird, das mit dem Zeitpunkt des Auslösens der elektrischen Entladung beginnt und bis zu einem Zeitpunkt reicht, an dem der Spannungswert dem 0,007-fachen dieses Anfangswerts entspricht.

7. Elektro- oder Hybridfahrzeug, umfassend

- ein Fahrzeugstromnetz,
- ein Fahrzeugdatennetz,
- eine Sicherheitsvorrichtung, die im Falle eines Unfalls eine kapazitive elektrische Energie aus dem Fahrzeugstromnetz mittels mindestens eines Widerstands (PTC) entladen kann, wobei die Vorrichtung einen Spannungssensor (V) und einen Stromsensor (A) umfasst, die jeweils eine Spannung über dem mindestens einen Widerstand und einen Entladungsstrom messen, der durch den mindestens einen Widerstand fließt, und wobei die Spannungs- und Stromsensoren operativ mit dem Fahrzeugdatennetz verbunden sind,
- eine Verarbeitungseinheit (VCU), die operativ mit dem Fahrzeugdatennetz verbunden ist und eine Aktivierung der Sicherheitsvorrichtung bewirkt, und wobei die Verarbeitungseinheit dem Anspruch 6 entspricht.

## Revendications

1. Procédé de mesure d'une valeur de résistance d'une résistance (PTC) d'un dispositif de sécurité pour véhicules électriques ou hybrides agencé pour décharger une énergie électrique capacitive d'un réseau électrique de véhicule, en cas d'accident, le procédé comprenant la procédure consistant à déclencher une décharge électrique à travers ladite résistance et à calculer (étape 5) ladite valeur de résistance électrique comme le rapport entre une valeur de tension initiale, mesurée avant le déclenchement de la décharge électrique, et une valeur de courant initiale estimée égale à une valeur moyenne du courant de décharge multipliée par un facteur égal à 5 ou 5,035, dans lequel la valeur moyenne du courant est calculée dans un intervalle de temps commençant à un instant du déclenchement de la décharge électrique jusqu'à un instant où la valeur de tension est égale à 0,007 fois ladite valeur initiale.

2. Procédé selon la revendication 1, comprenant les étapes successives suivantes:

- (Etape 1) Acquisition de ladite mesure de tension initiale alors que l'interrupteur (SW) est ouvert,
- (Etape 2) Fermeture de l'interrupteur (SW) et mesure simultanée du courant de décharge et de la tension à travers la résistance, jusqu'à ce que la valeur mesurée de la tension dépasse (">") ledit seuil prédéterminé (S),
- (Etape 3) Détection de l'instant où la valeur de tension mesurée devient inférieure ("<") au seuil précité, puis
- (Etape 4) Calcul de la moyenne des valeurs de courant acquises et calcul du courant initial de la décharge comme produit de la moyenne des valeurs de courant acquises par ledit facteur.

3. Procédé selon l'une quelconque des revendications 1 ou 2, dans lequel ladite valeur moyenne du courant de décharge est calculée par une moyenne mobile.

4. Programme informatique comprenant des moyens de codage de programme adaptés pour mettre en œuvre toutes les étapes de l'une quelconque des revendications 1 à 3, lorsque ledit programme est exécuté sur une unité de traitement de véhicule (VCU) configurée pour commander et surveiller un dispositif de sécurité pour véhicules électriques ou hybrides agencé pour décharger une énergie électrique capacitive d'un réseau électrique de véhicule, en cas d'accident.

5. Moyen lisible par ordinateur comprenant un programme enregistré, ledit moyen lisible par ordinateur comprenant un moyen de codage de programme adapté pour mettre en œuvre toutes les étapes de l'une quelconque des revendications 1 à 3, lorsque ledit programme est exécuté sur une unité de traitement de véhicule (VCU) configurée pour commander et surveiller un dispositif de sécurité pour véhicules électriques ou hybrides agencé pour décharger une énergie électrique capacitive d'un réseau électrique de véhicule, en cas d'accident.

6. Unité de traitement de véhicule (VCU) configurée pour commander un dispositif de sécurité de véhicule électrique ou hybride agencé pour décharger une énergie électrique capacitive d'un réseau électrique de véhicule, en cas d'accident, l'unité de traitement étant configurée pour mesurer une valeur de résistance électrique d'une résistance dudit dispositif de sécurité en déclenchant une décharge électrique à travers ladite résistance et en calculant ladite valeur de résistance électrique comme le rapport entre une valeur de tension initiale, mesurée avant le déclenchement de la décharge électrique, et une valeur de courant initiale égale à une valeur moyenne du courant de décharge multipliée par un facteur égal à 5 ou 5,035, dans laquelle la valeur moyenne du courant est calculée dans un intervalle de temps commençant à partir d'un instant du déclenchement de la décharge électrique jusqu'à un instant où la valeur de la tension est égale à 0,007 fois ladite valeur initiale.

7. Véhicule électrique ou hybride comprenant

- un réseau électrique du véhicule,
- un réseau de données du véhicule,
- un dispositif de sécurité agencé pour décharger une énergie électrique capacitive du réseau électrique du véhicule au moyen d'au moins une résistance (PTC), en cas d'accident, le dispositif comprenant un capteur de tension (V) et un capteur de courant (A) agencés pour mesurer respectivement une tension à travers au moins une résistance et un courant de décharge traversant ladite au moins une résistance, et dans lequel lesdits capteurs de tension et de courant sont connectés de manière opérationnelle audit réseau de données du véhicule,
- une unité de traitement (VCU), connectée de manière opérationnelle audit réseau de données du véhicule et agencée pour provoquer une activation dudit dispositif de sécurité, et dans lequel ladite unité de traitement est conforme à la revendication 6.

**Fig. 1**

**Fig. 2**

Fig. 3

EP 4 270 021 B1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014285210 A
- US 2013035819 A
- US 2013257446 A